# FASCICULE DE BREVET EUROPEEN

(11) **EP 2 414 276 B1**
(45) Date de publication et mention de la délivrance du brevet: **06.02.2019**
(21) Numéro de dépôt: 10712401.8
(22) Date de dépôt: 26.03.2010
(51) Int. Cl.: B81C 1/00

(54) **REALISATION D'UN DISPOSITIF MICRO-ELECTRONIQUE COMPORTANT UN COMPOSANT NEMS EN SILICIUM MONOCRISTALLIN ET UN TRANSISTOR DONT LA GRILLE EST REALISEE DANS LA MEME COUCHE QUE LA STRUCTURE MOBILE DE CE COMPOSANT**
HERSTELLUNG EINER EIN NEMS-BAUTEIL AUS MONOKRISTALLINEM SILIZIUM UND EINEN TRANSISTOR UMFASSENDEN MIKROELEKTRONISCHEN VORRICHTUNG, DESSEN GATE IN DER GLEICHEN SCHICHT WIE DIE BEWEGLICHE STRUKTUR DES BAUTEILS HERGESTELLT IST
PRODUCTION OF A MICROELECTRONIC DEVICE COMPRISING A MONOCRYSTALLINE SILICON NEMS COMPONENT AND A TRANSISTOR, THE GATE OF WHICH IS PRODUCED IN THE SAME LAYER AS THE MOVABLE STRUCTURE OF SAID COMPONENT

(30) Priorité: 30.03.2009 FR 0951986
(43) Date de publication de la demande: 08.02.2012
(73) Titulaire: Commissariat à l'Énergie Atomique et aux Énergies Alternatives, 75015 Paris (FR)
(72) Inventeur: OLLIER, Eric, F-38100 Grenoble (FR); BERTHELOT, Audrey, F-38330 St Ismier (FR)
(74) Mandataire: Ilgart, Jean-Christophe
(86) Numéro de dépôt international: PCT/EP2010/054023
(87) Numéro de publication internationale: WO 2010/112428

(56) Documents cités:
- FR-A- 2 906 238
- US-A- 5 808 331
- US-A- 6 087 701
- US-A1- 2006 270 238

## Description

### DOMAINE TECHNIQUE

La présente invention concerne le domaine des dispositifs microélectroniques dotés d'au moins un composant NEMS (NEMS pour « Nano Electro-Mechanical Systems ») et/ou MEMS (MEMS pour « Micro Electro Mechanical Systems ») co-intégrés sur un même substrat avec au moins un transistor.

L'invention permet de former une structure mobile d'un composant MEMS ou NEMS dans du Si monocristallin, et un transistor à partir d'une même couche semi-conductrice, et apporte des améliorations notamment en termes de nombre d'étapes de procédé de fabrication nécessaires pour réaliser le composant MEMS et le circuit électronique.

### ART ANTERIEUR

Il est connu de vouloir intégrer sur un même substrat, une structure de NEMS et/ou de MEMS avec un ou plusieurs transistors d'un circuit CMOS.

Pour cela, des méthodes différentes existent, et ont été présentées par exemple dans le document : *"*On Integrated CMOS-MEMS System-on-Chip", Soumik Ghosh et Magdy Bayoumi, conférence IEEE-NEWCAS 2005, pp. 31-34*.*

Une approche appelée « pre-CMOS », prévoit la réalisation d'une structure MEMS avant de réaliser les composants du circuit CMOS.

Selon une autre approche, dite « intermediate-CMOS », on interrompt les étapes de réalisation du circuit CMOS dites de « Front-End » ou de « Back-End » afin de réaliser le MEMS.

Une troisième approche dite « post-CMOS », prévoit de définir la structure mobile MEMS après les composants CMOS, ce qui impose des contraintes importantes sur le choix des matériaux et des conditions du procédé utilisés afin de respecter des contraintes de budget thermique.

Un inconvénient commun à ces différentes approches est lié au nombre d'étapes de fabrication nécessaires pour réaliser le composant MEMS et le circuit CMOS.

Le document : « From VHF to UHF CMOS-MEMS monolithically integrated resonators », Teva et al., IEEE-MEMS Janvier 2008*,* divulgue un procédé de réalisation d'un dispositif microélectronique dans lequel la structure mécanique mobile d'un MEMS est réalisée à partir de couches de polysilicium également utilisées pour former la grille d'un transistor MOS.

L'utilisation du silicium polycristallin pour réaliser la structure mobile d'un MEMS limite cependant les performances mécaniques ainsi que la fiabilité de cette structure MEMS.

Le document FR 2 906 238 divulgue la fabrication d'une structure MEMS en silicium monocristallin, co-intégré avec un transistor. Le transistor et la structure MEMS sont réalisés à l'aide d'une technologie SON (SON pour « Silicon on Nothing ») dans laquelle le canal des transistors est maintenu au dessus d'une cavité.

Pour réaliser les transistors en technologie SON, on peut effectuer une gravure sélective d'une première zone de SiGe par rapport à une deuxième zone de Si reposant sur cette première zone et destinée à former le canal. Le retrait total du SiGe est difficile à obtenir lorsque la dimension critique de la zone de SiGe est importante, ce qui impose de réaliser des transistors de faible taille de canal.

Le document US 2006/270238 présente un procédé de réalisation d'un dispositif microélectronique comprenant, sur un même substrat, un composant électromécanique doté d'une structure mobile en matériau semi-conducteur et un transistor réalisés dans des couches différentes.

Le document US 6 087 701 concerne un procédé de réalisation d'un dispositif microélectronique comprenant, sur un même substrat, un composant électromécanique doté d'une structure mobile en matériau semi-conducteur et un transistor dont la structure de canal est réalisée dans une même couche que la structure mobile.

Le document US 5 808 331 présente un procédé dans lequel on vient réaliser la structure mobile d'un composant électro-mécanique et la grille d'un transistor dans une couche en polysilicium.

Un autre document : « A monolithic high-g SOI-MEMS accelerometer for measuring projectile launch and flight accelerations », Bradford D. Davis et al., IEEE 2004*,* divulgue un procédé d'intégration dans lequel on forme, dans une même couche de silicium, une structure mobile d'un MEMS et des canaux de transistors d'un circuit CMOS.

Le procédé présenté dans ce document est limité en termes de résolution de lithographie de la structure mécanique du MEMS, qui est réalisée après celle des lignes métalliques d'interconnexion.

Il se pose le problème de trouver un nouveau procédé de réalisation d'un dispositif microélectronique comportant un système électromécanique de type MEMS ou NEMS doté d'une structure mobile en semi-conducteur monocristallin, ainsi qu'un ou plusieurs transistors formés sur un même substrat, dans lequel, notamment, le nombre d'étapes de fabrication nécessaires pour réaliser la structure MEMS et les transitors est réduit.

L'invention concerne également un dispositif mis en oeuvre par un procédé tel que décrit précédemment.

### EXPOSÉ DE L'INVENTION

L'invention concerne un procédé de réalisation selon la revendication 1 d'un dispositif microélectronique comprenant, sur un même substrat, au moins un composant électro-mécanique doté d'une structure mobile en matériau semi-conducteur monocristallin et des moyens d'actionnement et/ou de détection de la structure mobile, et d'au moins un transistor. Le procédé comprend les étapes suivantes :
a) prévoir un substrat doté d'au moins une première couche semi-conductrice comportant au moins une région donnée dans laquelle une zone de canal du transistor est prévue, une couche isolante recouvrant la première couche semi-conductrice,
b) gravure d'une deuxième couche semi-conductrice à base de matériau semi-conducteur donné reposant sur ladite couche isolante recouvrant ladite première couche semi-conductrice, la gravure étant prévue de manière à former au moins un motif de la dite structure mobile du composant dans une zone de matériau semi-conducteur monocristallin du matériau de la deuxième couche semi-conductrice et au moins un motif de grille en regard de ladite région donnée.

Selon le procédé suivant l'invention, la grille du transistor et la structure mobile sont définies par gravure en une étape.

Le procédé suivant l'invention, peut être appliqué à la réalisation de transistors de différentes tailles de canal, et s'applique notamment à la réalisation de transistors d'amplification qui nécessitent parfois une taille minimale de canal.La première couche semi-conductrice peut appartenir à un substrat massif, communément appelé « bulk ».

Dans ce cas, le procédé comprend en outre, préalablement à l'étape b), la formation de ladite couche isolante sur la première couche semi-conductrice du substrat.

Selon cette première possibilité de mise en oeuvre, le procédé comprend en outre : la gravure au moins partielle de ladite couche isolante en regard de ladite région donnée pour former une zone de diélectrique de grille pour ledit transistor. Cette zone de diélectrique de grille peut être formée par gravure de ladite couche isolante, puis oxydation du susbtrat de manière à former une zone d'oxyde de semi-conducteur. Cela peut permettre de former un diélectrique de grille de bonne qualité. Le procédé comprend en outre, la réalisation d'au moins une ouverture dans ladite couche isolante dévoilant la première couche semi-conductrice, la formation d'au moins une zone sacrificielle semi-conductrice au fond de cette ouverture, puis la formation de ladite deuxième couche semi-conductrice par croissance.

La zone sacrificielle semi-conductrice est à base de matériau semi-conducteur cristallin.

Par croissance on peut ainsi former la deuxième couche semi-condutrice avec une zone de matériau semi-conducteur monocristallin sur ladite zone sacrificielle semi-conductrice et une zone de matériau semi-conducteur polycristallin sur ladite zone de diélectrique de grille et sur la couche isolante.

Le matériau semi-conducteur cristallin de la zone sacrificielle semi-conductrice peut être à base d'un matériau choisi de manière à pouvoir être gravé sélectivement vis-à-vis des première et deuxième couches semi-conductrices.

Selon une possibilité, la première couche semi-conductrice peut être à base de Si ou de Ge ou de SiGe.

Selon une possibilité, la deuxième couche semi-conductrice peut être à base de Si ou de Ge ou de SiGe.

Le matériau semi-conducteur cristallin de la zone sacrificielle peut être du Si_{y}Ge_{1-y} en particulier lorsque la première couche semi-conductrice et la deuxième couche semi-conductrice sont à base de Si.

Selon une possibilité, le procédé peut comprendre en outre, après la formation de la zone sacrificielle semi-conductrice:
- la formation d'au moins une deuxième couche isolante, de manière à recouvrir la deuxième couche semi-conductrice et entourer les flancs de la structure mobile,
- le retrait d'une épaisseur donnée de ladite deuxième couche isolante en regard de ladite structure,
- la libération de la structure mobile par gravure sélective du matériau de la deuxième couche isolante vis-à-vis du matériau semi-conducteur de la deuxième couche semi-conductrice.

Le procédé peut comprendre en outre, le retrait de la zone sacrificielle semi-conductrice.

Cela peut être réalisé avant la libération, et en particulier avant la gravure sélective du matériau de la deuxième couche isolante vis-à-vis du matériau semi-conducteur de la deuxième couche semi-conductrice ou pendant la libération, après ladite gravure sélective du matériau de la deuxième couche isolante vis-à-vis du matériau semi-conducteur de la deuxième couche semi-conductrice.

Selon une deuxième possibilité de mise en oeuvre qui ne fait pas partie de l'invention revendiquée, la première couche semi-conductrice peut être une couche de support d'un substrat SOI recouverte par ladite couche isolante du substrat SOI, ladite deuxième couche étant une couche de Si monocristallin du substrat SOI reposant sur ladite couche isolante.

Après l'étape b), le procédé peut comprendre en outre : la formation d'au moins une deuxième couche isolante, de manière à recouvrir la deuxième couche semi-conductrice et les flancs de la structure mobile, le procédé comprenant en outre les étapes de :
- retrait d'une épaisseur donnée de ladite deuxième couche isolante en regard de ladite structure mobile,
- libération de la structure mobile par gravure sélective du matériau de la deuxième couche isolante vis-à-vis du matériau semi-conducteur de la deuxième couche semi-conductrice.

La première couche isolante et la deuxième couche isolante peuvent être à base d'un même matériau diélectrique donné, la libération par gravure sélective comprenant le retrait d'une zone de la première couche isolante en regard de ladite structure mobile.

Le matériau diélectrique donné peut être du SiO₂. Dans ce cas, la gravure sélective peut être réalisée à l'aide de HF sous forme de vapeur.

Préalablement à l'étape de libération, une couche de protection peut être formée sur ladite deuxième couche semi-conductrice en regard dudit transistor.

Préalablement à ladite étape de libération, le procédé peut comprendre une formation de contacts et dans la deuxième couche isolante et d'éléments d'interconnexion au dessus de cette deuxième couche isolante.

La région donnée de la première couche semi-conductrice dans laquelle une zone de canal est prévue, peut être une zone dopée. Ainsi l'étape a) peut comprendre une étape de dopage de ladite région donnée.

Selon une possibilité de mise en oeuvre, la région peut être éventuellement une zone de semi-conducteur intrinsèque.

Les moyens d'actionnement et/ou de détection peuvent être sous forme d'électrodes, par exemple pour une détection capacitive, ou de lignes, par exemple pour une détection piézorésistive.

Au moins un motif dudit composant électromécanique peut être formé dans la couche semi-condutrice à l'étape b), par gravure, et de sorte que la grille du transistor est reliée à cette électrode.

Au moins un motif dudit composant peut être formé dans la deuxième couche semi-conductrice et relié électriquement à la grille du transistor par une connexion électrique formée par gravure dans la deuxième couche semin-conductrice au cours de l'étape b).

Ce motif peut être un motif d'électrode, par exemple d'une électrode de détection.

Cela permet de s'affranchir de différents niveaux d'interconnexions métalliques pour mettre en oeuvre la liaison électrique entre le composant électromécanique et le transistor.

On peut ainsi réduire le nombre d'étapes du procédé pour connecter ces composants, tout en limitant les phénomènes de capacités parasites entre le composant électro-mécanique et le circuit de traitement connecté à ce composant.

Etablir une liaison directe entre une électrode du composant électromécanique et la grille du transistor permet d'éviter une liaison par l'intermédiaire de niveaux d'interconnexions métalliques qui génère des capacités parasites.

En limitant les capacités parasites, il peut être possible de prévoir un gain du transistor plus faible, et de réduire ainsi la consommation.

Le transistor peut appartenir à un circuit analogique de traitement prévu directement en sortie du composant électro-mécanique et doté d'au moins un étage d'amplification du signal issu du composant électromécanique. On peut effectuer un traitement analogique du signal de sortie du composant électro-mécanique au plus près du composant électro-mécanique afin d'améliorer le rapport signal à bruit.

Le transistor peut être un transistor d'amplification ou agencé de manière à fonctionner comme transistor d'amplification.

Le transistor peut être utilisé pour réaliser l'amplification directe dans un montage en transimpédance du signal de sortie du composant électro-mécanique, par exemple un signal de sortie provenant d'une variation de capacité consécutive au déplacement de la structure mobile du composant.

Le transistor peut être doté d'une grille de dimension critique comprise entre 0.13 µm et 0.35 µm.

Le composant électro-mécanique peut être un composant NEMS. Dans ce cas, la structure mobile peut avoir une dimension critique comprise entre 1 nm et 1 µm.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

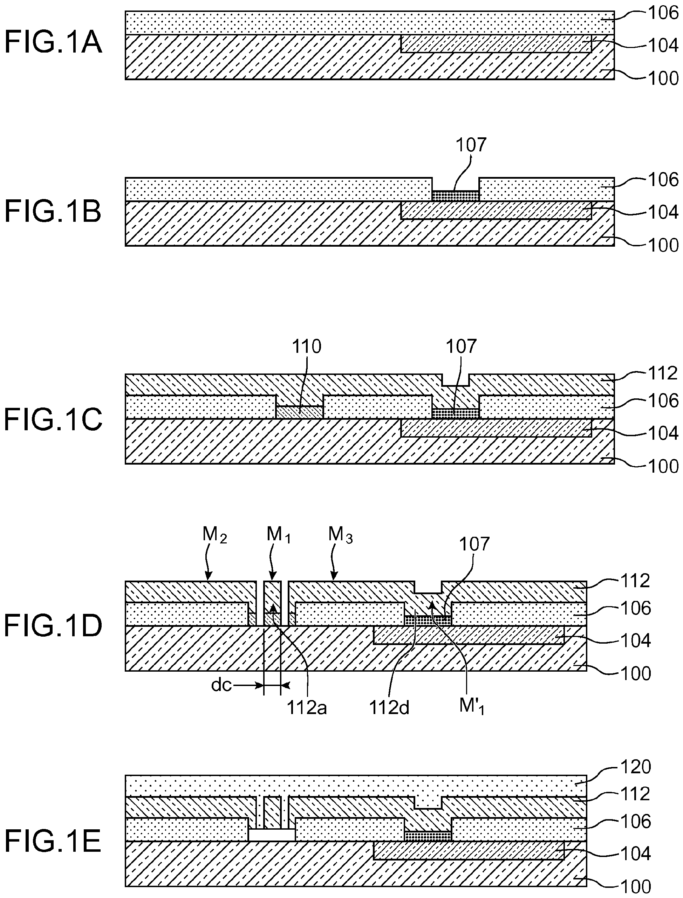

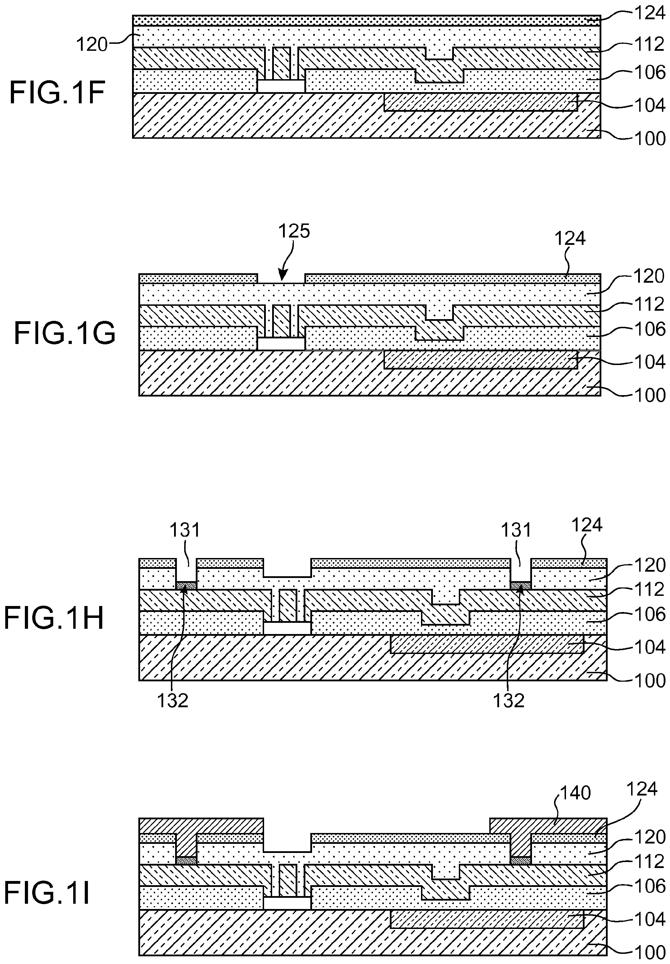

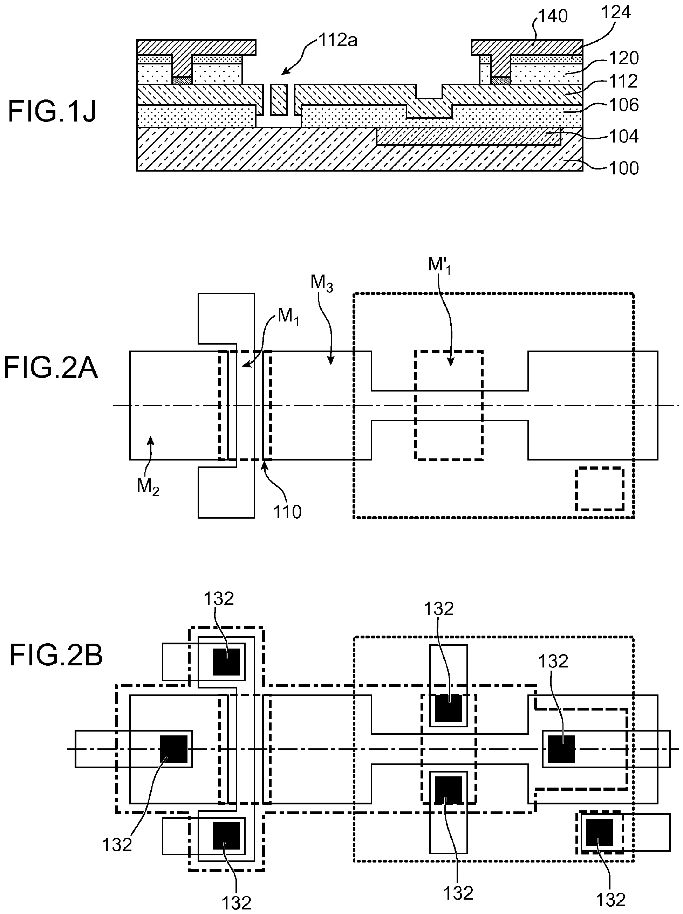

- les figures 1A-1J et 2A-2B, illustrent un exemple de procédé de réalisation d'un dispositif microélectronique suivant l'invention en comprenant au moins un composant électromécanique et un transistor formés sur un même substrat, la grille et la structure mobile du composant électro-mécanique étant formées à partir d'une même couche de Si,

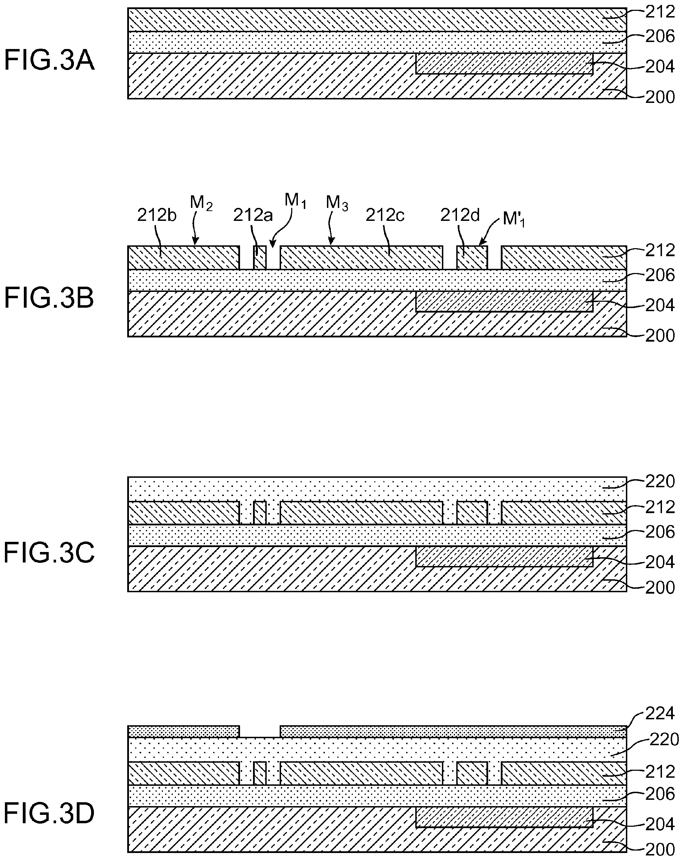

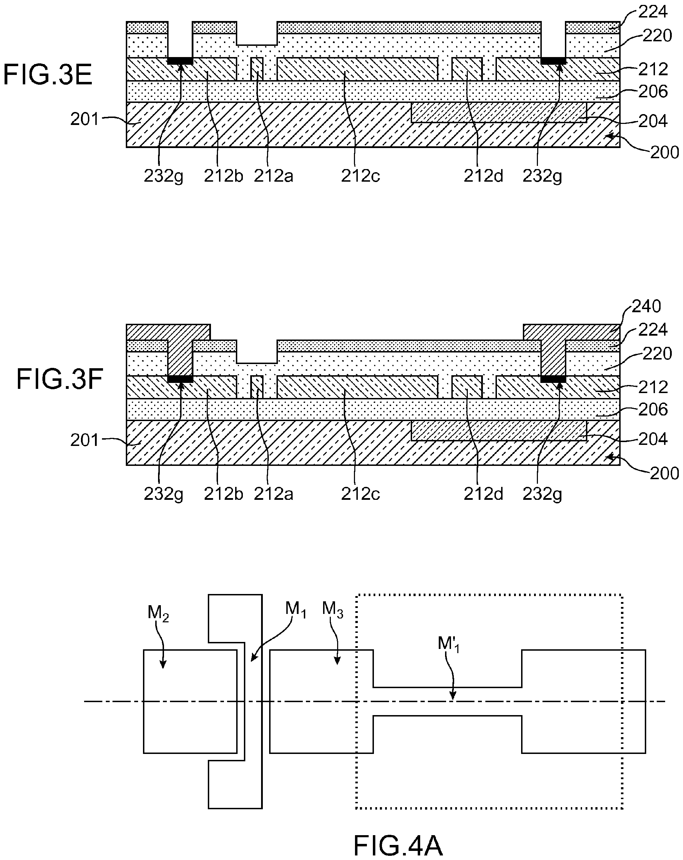

- les figures 3A-3F et 4A-4B, illustrent un autre exemple de procédé de réalisation d'un dispositif microélectronique comprenant au moins un composant électromécanique et d'un transistor formés sur un même substrat, la grille et la structure mobile du composant électro-mécanique étant formées à partir d'une même couche de Si monocristallin,

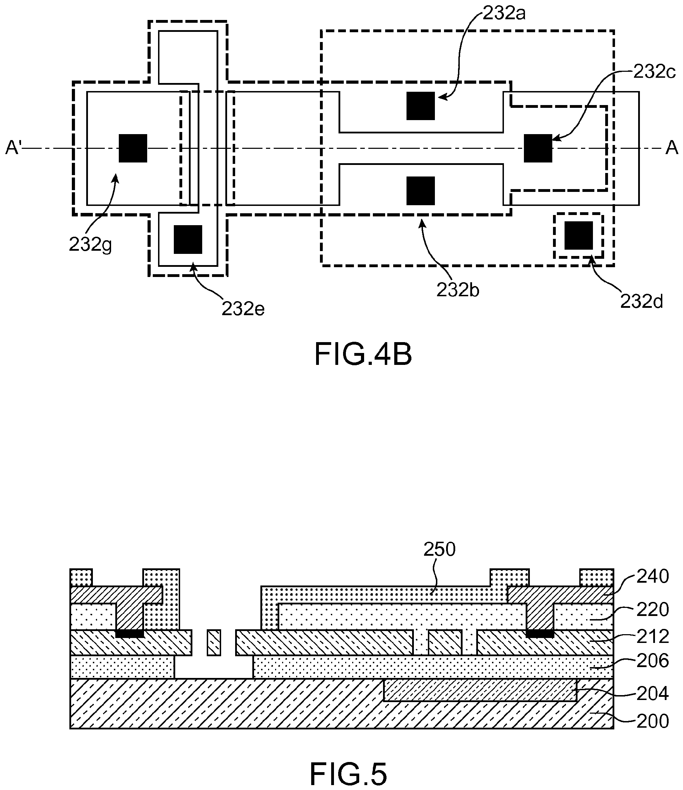

- la figure 5 illustre une variante d'étape de libération d'une structure mobile d'un composant électromécanique effectuée au cours d'un exemple de procédé suivant l'invention,

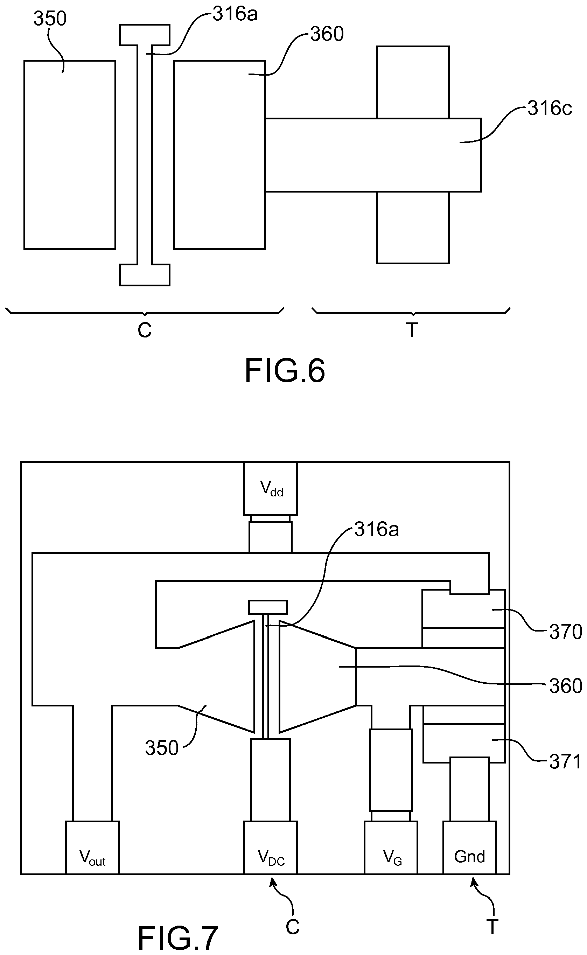

- les figures 6 et 7 illustrent un exemple de dispositif microélectronique mis en oeuvre à l'aide d'un procédé suivant l'invention et doté d'un composant électromécanique MEMS ou NEMS ayant une structure mobile en Si monocristallin et au moins un transistor dont la grille a été formée dans la même couche que ladite structure mobile,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé de réalisation d'un dispositif microélectronique suivant l'invention, va à présent être donné en liaison avec les figures 1A-1J, et 2A-2B (le dispositif en cours de réalisation étant représenté sur les figures 1A-1J selon une vue en coupe transversale, seuls les éléments situés dans le plan de coupe étant représentés sur ces figures).

Le matériau de départ de ce procédé peut être un substrat 100, qui peut être un substrat massif encore appelé « bulk », à base d'un matériau semi-conducteur tel que du silicium.

Dans ce substrat 100, on peut définir tout d'abord un caisson ou une zone dopée 104, dans laquelle au moins une zone de canal d'un transistor est prévue.

Cette zone 104 dopée peut être réalisée par exemple par implantation du substrat 100 par un dopage qui peut être par exemple de type P, par exemple à l'aide de Bore et selon une concentration de l'ordre de 1*10¹⁷ atomes*cm⁻³.

Selon une possibilité, la région 104 du substrat 100 dans laquelle une zone de canal de transistor est destinée à être réalisée, peut être une zone de Si intrinsèque.

Une couche isolante 106 est ensuite formée sur le substrat 100. Le matériau diélectrique de la couche isolante 106, est un diélectrique choisi de manière à pouvoir être gravé de manière sélective vis-à-vis du silicium. Le matériau diélectrique de la couche isolante 106 peut être par exemple du SiO₂ formé par oxydation thermique du substrat, de manière à réaliser une épaisseur diélectrique qui peut être par exemple de l'ordre d'une centaine de nanomètres (figure 1A) .

Ensuite, on grave, par exemple par gravure humide, la couche isolante 106, de manière à former au moins une ouverture dans une zone de cette couche 106 située en regard de la zone dopée 104, l'ouverture dévoilant cette zone dopée 104. Dans cette ouverture, on forme ensuite une zone de diélectrique 107 de grille d'épaisseur réduite, par exemple comprise entre 5 et 10 nanomètres. Le diélectrique de grille peut être formé par exemple par oxydation thermique du substrat 100. Cela peut permettre de former un diélectrique de bonne qualité (figure 1B).

D'autres ouvertures (non représentées sur la figure 1B) dans la couche isolante 106, dans lesquelles des contacts sont destinées à être formés, peuvent être également réalisées.

Ensuite, on forme au moins un trou dévoilant le substrat 100 dans la couche isolante 106, dans une région dans laquelle une partie d'au moins un composant électro-mécanique du type NEMS (NEMS pour Nano Electro-Mechanical System) ou MEMS (MEMS pour Micro Electro-Mechanical System) est destiné à être réalisée. Ce trou peut être formé par exemple par gravure anisotrope de la couche isolante 106.

Au fond du trou, on forme ensuite une zone 110 à base de Si_{1-y}Ge_{y} (avec y par exemple de l'ordre de 0.6), par croissance par épitaxie sur le substrat 100, par exemple de manière à obtenir une épaisseur de l'ordre de 60 nanomètres.

L'épitaxie réalisée peut être sélective de sorte que le Si_{1-y}Ge_{y} est formé uniquement sur des zones du substrat 100 situées au fond du trou. On forme ainsi du Si_{1-y}Ge_{y} cristallin.

Ensuite, on fait croitre une couche de Si, sur la ou les zones 110 de Si_{1-y}Ge_{y} cristallin, ainsi que sur la couche isolante 106. Cela conduit à former du Si monocristallin sur la zone 110 à base de Si_{1-y}Ge_{y}, et du Si polycristallin sur la couche de diélectrique 106 (figure 1C).

Puis, on forme des motifs M₁, M₂, M₃, et M'₁, dans la couche 112 de Si (figure 1D), dont au moins un motif M₁ d'une structure mobile 112a du composant électromécanique NEMS ou MEMS, au moins un motif M₂ d'une partie 112b destinée à former une première électrode d'actionnement et/ou de détection du composant électro-mécanique, au moins un motif M₃ d'une partie 112c destinée à former une deuxième électrode d'actionnement et/ou de détection du composant électromécanique, ainsi qu'au moins un motif M'₁ d'une partie 112d destinée à former une grille d'un transistor. La structure mobile 112a peut comprendre une partie sous forme d'un barreau. Ce barreau peut avoir une dimension critique dc qui peut être comprise, par exemple, entre 10 nanomètres et 1 micromètre dans le cas où on réalise une structure NEMS.

Le motif M'₁ de grille de transistor formé dans la couche 112 peut être réalisé de sorte que ce dernier est relié à un motif d'électrode du composant électro-mécanique. Ainsi selon cette possibilité de mise en oeuvre, le composant et le transistor peuvent être connectés entre eux et éventuellement polarisés par un même potentiel, sans qu'il soit nécessaire de prévoir une interconnexion à l'aide d'un niveau métallique supérieur.

Dans ce cas là, la liaison entre le composant électromécanique et le transistor peut être prévue avec une dimension critique supérieure à la plus large dimension de la structure mécanique mobile destinée à être libérée, de manière à ne libérer que cette structure mobile lors d'une étape ultérieure de libération de cette structure mobile (figure 1D et figure 2A, la figure 2A montrant en vue de dessus les motifs réalisés dans la couche de Si monocristallin pour former des parties du composant et du transistor, la zone de SiGe 110 et les zones dans lesquelles des ouvertures ont été réalisées dans la couche de diélectrique étant délimitées par des traits discontinus sur cette figure, tandis que la zone 104 est délimitée par des pointillés).

Le transistor en cours de réalisation peut être un transistor d'un circuit analogique ayant au moins une fonction d'amplification et qui peut être situé directement en sortie du composant électromécanique. Ce circuit analogique peut également comporter d'autres transistors (non représentés sur les figures). Le transistor peut être un transistor d'amplification comportant un canal par exemple de longueur comprise entre 0.1 µm et plusieurs µm ou plusieurs dizaines de micromètres, la dimension critique de la grille étant comprise par exemple entre 0.13 µm et 0.35 µm.

La réalisation de ces motifs M₁, M₂, M₃, et M'₁ peut comprendre une étape de photolithographie lors de laquelle on expose une couche de résine à un rayonnement ultra-violet, puis de gravure à travers cette couche de résine.

Selon une variante, la réalisation de ces motifs peut comprendre une étape de photolithographie lors de laquelle on expose une couche de résine à un rayonnement ultra-violet lointain, puis on expose cette couche de résine à un faisceau d'électrons (communément appelé « e-beam »), puis de gravure anisotrope à travers la couche de résine (non représentée). Cette lithographie hybride utilisant la gravure par faisceau d'électrons permet de réaliser certains motifs de taille très faible par exemple de l'ordre de plusieurs nanomètres ou plusieurs dizaines de nanomètres.

Puis, on effectue un retrait de la zone à base de Si_{1-y}Ge_{y}. Ce retrait peut être réalisé par exemple par gravure isotrope de Si_{1-y}Ge_{y}, par exemple à l'aide d'une gravure plasma qui peut être réalisée par exemple à l'aide de CF₄

On dépose ensuite (figure 1E) une couche de matériau diélectrique 120 sur la couche de Si 112, par exemple une couche de SiO₂ permettant notamment de protéger et maintenir le composant électro-mécanique et en particulier sa structure mobile 112a. Le matériau diélectrique 120 peut être par exemple déposé par un procédé TEOS ou SACVD, avec une épaisseur par exemple de l'ordre de 150 nanomètres. Le matériau diélectrique 120 peut être déposé de manière à recouvrir la couche 112 de Si et entourer la structure mobile 112a du composant (figure 1E).

Ce dépôt peut être suivi d'une étape de polissage mécanico-chimique (communément appelée CMP).

Ensuite, on peut doper les zones de source, de drain, et de grille du transistor, ainsi que la structure NEMS ou MEMS, par exemple en réalisant une implantation.

Dans le cas où, avantageusement, la couche de Si 112 relie la structure du composant électromécanique MEMS ou NEMS au transistor, la zone de cette couche formant la liaison entre le composant électromécanique et le transistor, peut être également dopée par implantation.

Pour cela, un dopage N+, par exemple avec du phosphore peut être par exemple réalisé, selon une concentration qui peut être par exemple de l'ordre de 1*10¹⁹ atomes*cm⁻³, ou comprise entre 1*10¹⁸ atomes*cm⁻³ et 1*10²¹ atomes*cm⁻³.

Ensuite, une autre implantation, par exemple de type P++, de certaines zones du caisson 104 peut être réalisée afin de former des contacts ohmiques.

Puis, une autre implantation, par exemple de type N++, de certaines zones de la couche de Si 112 peut être effectuée afin de former des contacts de type ohmique pour la grille, pour la source, pour le drain, ainsi que pour les électrodes du composant électromécanique.

Ensuite, on peut déposer une autre couche de matériau diélectrique 124 supplémentaire sur la couche de matériau diélectrique 120. Le dépôt de cette couche peut être conforme.

Les matériaux diélectriques 120, et 124 sont choisis de manière à pouvoir être gravés sélectivement vis-à-vis du silicium monocristallin, et peuvent être du SiO₂.

Les couches empilées de matériaux diélectriques 120, et 124 forment une couche isolante dont on peut retirer ensuite une portion dans une zone située au-dessus de la structure mécanique 112a mobile du composant électromécanique MEMS ou NEMS. Ce retrait localisé des couches diélectriques 120, 124, peut être effectué pour permettre ultérieurement de libérer la structure 112a sans altérer le reste de la couche semi-conductrice 112 (figures 1G et 1H)).

Puis (figure 1H), on réalise des ouvertures 131 dans les couches diélectriques 120 et 124, de manière à dévoiler la couche 112 de Si monocristallin. On forme alors des contacts 132 au fond de ces ouvertures 131, par exemple par siliciuration de la couche 112, de manière à former des zones à base de PtSi ou de NiSi par exemple.

On peut ensuite réaliser un premier niveau métallique d'interconnexion, en déposant dans les ouvertures 131, un métal 140, ou un alliage métallique, par exemple de l'AlSi remplissant les ouvertures 131 et recouvrant la couche diélectrique 124, dans lequel on forme des pistes ou des lignes (figure 1I, et figure 2B illustrant le dispositif selon une vue de dessus, une fois le premier niveau métallique d'interconnexion réalisé).

Un recuit du métal peut être ensuite éventuellement effectué. Un recuit d'activation des dopants peut être également réalisé.

Puis, on effectue une libération de la structure mécanique 112a mobile du composant électromécanique. Cette libération peut être mise en oeuvre par gravure isotrope des couches diélectriques 120 et 124.

Pour libérer la structure 112a tout en évitant de graver inutilement d'autres parties de la couche 112 de Si monocristallin, l'empilement des couches diélectriques 120 et 124 est prévu avec une épaisseur inférieure dans une zone située au-dessus de la structure 112a mobile. La libération peut être réalisée par exemple à l'aide de HF. L'utilisation de HF sous forme de vapeur peut permettre de limiter les risques de collage de la structure mobile 112a lors de sa libération (figure 1J).

Selon une variante de l'exemple de procédé qui vient d'être donné, la couche diélectrique 124 peut être formée par dépôt non-conforme. Dans ce cas, la libération de la structure 112a mobile peut être réalisée par gravure anisotrope des couches diélectriques 120 et 124.

Dans cet exemple de procédé on peut former une épaisseur de matériau diélectrique différente pour isoler le composant électro-mécanique du substrat et pour réaliser l'oxyde de grille du transistor.

La couche semi-conductrice dans laquelle sont réalisés la structure du composant électromécanique et le transistor peut également présenter des différences d'épaisseurs localisées. Par exemple, on peut prévoir une épaisseur plus importante en regard de la structure mobile du composant électromécanique que pour la grille du transistor.

Cela peut être obtenu, par exemple à l'aide de gravures partielles, de reprises d'épitaxies, ou des épitaxies différentes.

Un autre exemple de procédé de réalisation d'un dispositif microélectronique, va à présent être donné en liaison avec les figures 3A-3F, et 4A-4B (le dispositif étant vu sur les figures 3A-3F selon une vue en coupe transversale, seuls les éléments situés dans le plan de coupe étant représentés sur ces figures).

Le matériau de départ de ce procédé est dans cet exemple, un substrat 200, de type SOI (SOI pour « Silicon On Insulator » ou silicium sur isolant) qui peut être formé d'une couche de support 201 semi-conductrice en silicium, d'une couche isolante 206 d'oxyde enterré (« burried oxide » selon la terminologie anglo-saxonne), et d'une fine couche semi-conductrice 212 en Si mono-cristallin.

Dans la couche de support 201 du substrat SOI, on réalise tout d'abord un caisson, c'est-à-dire une zone dopée 204 prévue notamment pour au moins un canal de transistor. Ce dopage peut être réalisé par photolithographie d'une couche (non représentée) puis implantation à travers des ouvertures formées dans cette couche, de manière à doper certaines zones du support 201, par exemple selon un dopage P, qui peut être réalisé à l'aide de Bore, selon une concentration par exemple de 1^{e}17 atomes*cm⁻³.

Ensuite, on défini dans la couche semi-conductrice en Si mono-cristallin 212, des motifs M₁, M₂, M₃, d'au moins un composant électro-mécanique de type NEMS ou MEMS dont au moins un motif M₁ d'une structure 212a destinée à former la partie mobile du composant électromécanique, ainsi que des motifs M₂, M₃ d'électrodes 212b, 212c de ce composant.

On réalise également des motifs d'au moins un transistor, et notamment, un motif M'₁ d'une électrode de grille 212d.

La couche semi-conductrice 212 peut être avantageusement structurée de sorte qu'une électrode du composant électro-mécanique formée dans cette couche est reliée à la grille du transistor, ces deux éléments pouvant être polarisés par l'intermédiaire d'un même potentiel de polarisation (figure 3B et figure 4A, la figure 4A montrant les motifs réalisés dans la couche semi-conductrice 212 selon une vue de dessus, la zone 204 dopée située sous la couche semi-conductrice 212 étant également représentée).

Les motifs dans la couche de Si monocristallin peuvent être réalisés par photolithographie, puis gravure, par exemple une gravure anisotrope, qui peut être réalisée à l'aide d'un plasma utilisant par exemple du SF₆.

Selon une variante, les motifs peuvent être obtenus à l'aide d'une étape de photolithographie, ou à l'aide d'une étape de photolithographie optique DUV (DUV pour « Deep Ultra Violet ») pour former certains motifs, et de lithographie par faisceau d'électrons pour réaliser certains autres motifs de faible taille.

Ensuite (figure 3C), on forme une couche de matériau diélectrique 220, de manière à recouvrir les motifs réalisés dans la couche de Si monocristallin 212 et à rendre plan l'empilement de couches. Cela peut être réalisé par dépôt d'un oxyde de silicium, par exemple par procédé TEOS, ou SACVD (SACVD pour « Sub-Atmospheric Chemical Vapor Déposition ») de manière à former une couche d'épaisseur par exemple de l'ordre de 150 nanomètres. Le matériau diélectrique 220 est choisi de manière à pouvoir être gravé sélectivement vis-à-vis du Si monocristallin de la couche 212. Une étape de polissage CMP peut être ensuite réalisée.

Puis, à l'aide d'étapes de photolithographie et d'implantation, on effectue un dopage de la source, du drain, de la grille du transistor, ainsi que d'au moins certaines zones du composant électro-mécanique, et éventuellement de la partie reliant le transistor avec ce composant.

Ce dopage peut être réalisé par exemple par dopage N+, avec du phosphore, selon une concentration par exemple de 1^{e19} atomes*cm⁻³ ou compris entre 1^{e18} atomes*cm⁻³ et entre 1^{e21} atomes*cm⁻³.

Un recuit de diffusion peut être ensuite effectué pour permettre d'homogénéiser la répartition des dopants, notamment dans l'épaisseur du silicium monocristallin de la zone du composant MEMS ou NEMS.

Ensuite, à l'aide d'étapes de photolithographie et d'implantation, on peut doper à nouveau le caisson 204, et en particulier des zones de ce dernier dans laquelle au moins un contact ohmique avec un élément d'interconnexion métallique est destiné à être réalisé, par exemple par dopage P++.

Puis, on dépose une deuxième couche de matériau diélectrique 224, telle qu'une couche d'oxyde de silicium afin, notamment, de réaliser une isolation électrique des structures en silicium mono-cristallin vis-à-vis des niveaux métalliques d'interconnexion destinés à être réalisés ultérieurement.

Un amincissement de la deuxième couche diélectrique 224 dans une zone située au dessus du composant électro-mécanique, peut être ensuite réalisé (figure 3D). Les épaisseurs des couches diélectriques 220 et 224 et la répartition de ces couches sont prévues en fonction d'une étape ultérieure de libération finale de la structure mobile du composant électro-mécanique. De même que pour le matériau diélectrique 220, le matériau diélectrique 224 est choisi de manière à pouvoir être gravé de manière sélective vis-à-vis du silicium monocristallin.

Ensuite, on forme une pluralité de contacts, parmi lesquels figurent des contacts 232a, 232b, pour les zones de source et de drain, au moins un contact 232c qui peut être pour la grille 212d du transistor et partagé par une des électrodes du composant électro-mécanique, un contact 232d pour le caisson 204, un contact 232e pour la partie mobile du composant électromécanique, et un contact 232g pour une électrode du composant électromécanique. Ces contacts 232a, 232b, 232c, 232d, 232e, 232g peuvent être réalisés par formation d'ouvertures dans les couches diélectriques 220, 224, de manière à dévoiler la couche de silicium monocristallin 212, puis siliciuration de la couche 212 de silicium monocristallin, par exemple de manière à former des zones à base par exemple de NiSi, ou de PtSi (figure 3E et figure 4B représentant selon une vue de dessus les motifs formés dans la couche de Si monocristallin, ainsi que les contacts réalisés sur cette couche).

Puis, on réalise des éléments d'interconnexion sur les contacts, par exemple par dépôt d'un alliage métallique 240 tel que de l'AlSi, puis photolithographie, puis gravure de cet alliage métallique 240 (figure 3F).

Ensuite, on peut effectuer un recuit du métal, et d'activation des dopants.

Puis, on libère la structure 212a mécanique mobile du composant électro-mécanique NEMS ou MEMS par gravure des matériaux diélectriques 220 et 224.

Pour cela, une gravure isotrope à l'aide de HF peut être effectuée dans le cas où les matériaux diélectriques 220 et 224 sont à base d'oxyde de silicium. L'emploi de HF sous forme de vapeur peut permettre de réduire les risques de collage de l'élément mobile 212a lorsque celui-ci est libéré.

L'épaisseur des couches diélectriques 220, 224 peut avoir été prévue plus faible en regard du composant électro-mécanique pour permettre sa libération et suffisamment importante au dessus du reste de l'empilement pour permettre de protéger les autres parties de l'empilement.

Selon une variante de réalisation (figure 5), une couche de protection 250 peut être prévue au dessus du transistor avant d'effectuer l'étape de libération du composant NEMS/MEMS, sans altérer les couches diélectriques 220, 224, au-dessus de ce dernier. Cette couche de protection 250 peut être par exemple à base de Si₃N₄, ou de Si amorphe, ou de HfO₂.

La couche de protection 250 peut être déposée par exemple de manière conforme après gravure anisotrope des couches 220, 224 et gravée localement de manière à permettre un accès au composant électromécanique.

Des structures d'isolation (non représentées) par exemple de type STI (STI pour « shallow trench isolation »), ou LOCOS peuvent être également réalisées.

Selon une possibilité de mise en oeuvre (non représentée) des espaceurs peuvent avoir été prévus pour améliorer les performances électriques du transistor.

Des zones implantées par exemple de type LDD peuvent être également réalisées.

Sur la figure 6, un exemple de dispositif microélectronique mis en oeuvre à l'aide d'un procédé suivant l'invention et doté d'un composant électromécanique NEMS et/ou MEMS (référencé C sur cette figure) ayant une structure mobile 316a en Si monocristallin et au moins un transistor (référencé T sur cette figure) dont la grille 316c a été formée dans la même couche 316 que ladite structure mobile est donné.

Le dispositif est également doté de moyens d'actionnement et/ou de détection de la structure mobile qui peuvent être de type électrostatique ou thermoélastique ou piézoélectrique, thermique, magnétique.

Sur la figure 6, le composant électromécanique C comporte des moyens d'actionnement sous forme d'une électrode 350 et des moyens de détection sous forme d'une électrode 360.

Le composant C peut être également doté de moyens de détection des mouvements de la structure mobile, par exemple de type capacitif ou piézorésistif.

Dans l'exemple de la figure 6, les moyens de détection sont dotés d'une électrode 360 formée dans la couche 316 et reliée à la grille 316 du transistor par l'intermédiaire de cette couche 316.

Une variante de ce dispositif est donnée sur la figure 7.

Selon cette variante, le drain 370 du transistor T est relié à l'électrode 350 d'actionnement du composant électro-mécanique et à un potentiel Vdd, tandis que la structure mobile 316a est sous forme d'un barreau mis à un potentiel Vdc. La grille 316c du transistor T est quant à elle connectée à l'électrode 360 de détection du composant et à un potentiel Vg, tandis que la source 371 du transistor T est mise à un potentiel de référence. Ce dispositif forme un oscillateur élémentaire. Ce type de dispositif est adapté pour des applications basse consommation, et peut éventuellement appartenir à un réseau comportant une pluralité de composants C et de transistors T associés. Un tel réseau peut être intégré par exemple dans un capteur chimique ou biologique, ou un capteur inertiel tel qu'un capteur de vibration, un accéléromètre, ou un gyromètre, ou dans un système résonant doté de résonateurs électro-mécaniques par exemple dans des applications RF de référence de temps, de filtres, ou de VCO.

## Revendications

1. Procédé de réalisation d'un dispositif microélectronique comprenant, sur un même substrat (100, 200), au moins un composant électro-mécanique (C) doté d'une structure mobile en matériau semi-conducteur monocristallin et de moyens d'actionnement et/ou de détection de la structure mobile, et d'au moins un transistor (T),
le procédé comprenant les étapes suivantes :
a) prévoir un substrat doté d'au moins une première couche semi-conductrice (100) comportant au moins une région (104) dans laquelle une zone de canal dudit transistor est prévue,
- former une couche isolante (106) sur le substrat (100), la couche isolante (106) étant placée sur ladite première couche semi-conductrice,
- réaliser au moins une première ouverture dans ladite couche isolante (106) dévoilant la première couche semi-conductrice (100),
- retrait d'une zone de ladite couche isolante (106) pour former au moins une deuxième ouverture dans ladite couche isolante (106), la deuxième ouverture dévoilant ladite région (104) dans laquelle une zone de canal dudit transistor et prévue,
- former une zone de diélectrique (107) de grille dans ladite deuxième ouverture,
- former au moins une zone sacrificielle semi-conductrice (110) en matériau semi-conducteur cristallin par croissance par épitaxie au fond de cette première ouverture, puis
- former une deuxième couche semi-conductrice (112) par croissance, de manière à former un matériau semi-conducteur monocristallin sur ladite zone sacrificielle semi-conductrice (110) et une zone de matériau semi-conducteur polycristallin sur ladite zone de diélectrique de grille,
b) graver la deuxième couche semi-conductrice (112) de manière à former, au moins un motif (M1) de la dite structure mobile du dit composant dans une zone de matériau semi-conducteur monocristallin (112a, 212a) de la deuxième couche semi-conductrice, et au moins un motif (M'1) de grille dudit transistor sur une zone de diélectrique de grille située en regard de ladite région dans laquelle la zone de canal dudit transistor est prévue.
c) retrait de la zone sacrificielle semi-conductrice (110).

2. Procédé selon la revendication 1, le matériau de la zone sacrificielle étant choisi de manière à pouvoir être gravé de manière sélective vis-à-vis du matériau de la première couche semi-conductrice et de la deuxième couche semi-conductrice.

3. Procédé selon l'une des revendications 1 ou 2 : le matériau de la zone sacrificielle étant du SiₓGe₁₋ₓ.

4. Procédé selon l'une des revendications 1 à 3, comprenant en outre, après la formation de la zone sacrificielle semi-conductrice (110), les étapes consistant à :
- former au moins une deuxième couche isolante (120-124), de manière à recouvrir la deuxième couche semi-conductrice (112) et entourer les flancs de la structure mobile (112a):
- retirer d'une épaisseur donnée de ladite deuxième couche isolante (120-124) en regard de ladite structure (112a),
- libérer la structure mobile (112a) par gravure sélective du matériau de la deuxième couche isolante (120-124) vis-à-vis du matériau semi-conducteur de la deuxième couche semi-conductrice (112).

5. Procédé selon l'une des revendications 1 à 4, dans lequel, à l'étape b), au moins un motif (M3) dudit composant (C) est formé dans la deuxième couche semi-conductrice (112) et relié au transistor, en particulier à la grille dudit transistor.

6. Procédé selon l'une des revendications 1 à 5, dans lequel, à l'étape b), au moins un motif (M3) dudit composant (C) est formé dans la deuxième couche semi-conductrice (112) et relié électriquement à la grille du transistor par une connexion électrique formée par gravure dans la deuxième couche semi-conductrice (112) au cours de l'étape b).

7. Procédé selon l'une des revendications 1 à 6, le transistor (T) étant un transistor d'amplification et/ou appartenant à un circuit analogique doté d'au moins un étage d'amplification.

## Patentansprüche

1. Verfahren zur Herstellung einer mikroelektronischen Vorrichtung, die auf ein und demselben Substrat (100, 200) wenigstens eine elektromechanische Komponente (C) umfasst, ausgestattet mit einer mobilen Struktur aus monokristallinem Halbleitermaterial und mit Mitteln zur Betätigung und/oder zur Erfassung der mobilen Struktur, sowie wenigstens einen Transistor (T),
wobei das Verfahren die folgenden Schritte umfasst:
a) Bereitstellen eines Substrats, das ausgestattet ist mit wenigstens einer ersten Halbleiterschicht (100), umfassend wenigstens eine Region (104), in der eine Kanalzone des Transistors vorgesehen ist,
- Bilden einer isolierenden Schicht (106) auf dem Substrat (100), wobei die isolierende Schicht (106) auf der ersten Halbleiterschicht platziert ist,
- Realisieren wenigstens einer ersten Öffnung in der isolierenden Schicht (106), wodurch die erste Halbleiterschicht (100) freigelegt wird,
- Entfernen einer Zone der isolierenden Schicht (106) zum Bilden wenigstens einer zweiten Öffnung in der isolierenden Schicht (106), wobei die zweite Öffnung die Region (104) freilegt, in der eine Kanalzone des Transistors vorgesehen ist,
- Bilden einer Gatedielektrikumszone (107) in der zweiten Öffnung,
- Bilden wenigstens einer Halbleiteropferzone (110) aus kristallinem Halbleitermaterial durch epitaktisches Wachstum am Boden dieser ersten Öffnung, und dann
- Bilden einer zweiten Halbleiterschicht (112) durch Wachstum derart, dass ein monokristallines Halbleitermaterial auf der Halbleiteropferzone (110) und eine Zone aus polykristallinem Halbleitermaterial auf der Gatedielektrikumszone gebildet wird,
b) Ätzen der zweiten Halbleiterschicht (112) derart, dass wenigstens ein Motiv (M1) der mobilen Struktur der Komponente in einer Zone aus monokristallinem Halbleitermaterial (112a, 212a) der zweiten Halbleiterschicht gebildet wird, sowie wenigstens ein Gatemotiv (M'1) des Transistors auf einer Gatedielektrikumszone, die gegenüber der Region liegt, in der die Kanalzone des Transistors vorgesehen ist,
c) Entfernen der Halbleiteropferzone (110).

2. Verfahren nach Anspruch 1, wobei das Material der Opferzone derart gewählt wird, dass es in selektiver Weise hinsichtlich des Materials der ersten Hableiterschicht und der zweiten Halbleiterschicht geätzt werden kann.

3. Verfahren nach einem der Ansprüche 1 oder 2, wobei das Material der Opferzone SiₓGe₁₋ₓ ist.

4. Verfahren nach einem der Ansprüche 1 bis 3, ferner umfassend nach der Bildung der Halbleiteropferzone (110) die folgenden Schritte:
- Bilden wenigstens einer zweiten isolierenden Schicht (120-124) derart, dass die zweite Halbleiterschicht (112) bedeckt wird und die Flanken der mobilen Struktur (112a) umgeben werden;
- Entfernen einer gegebenen Dicke der zweiten isolierenden Schicht (120-124) gegenüber der Struktur (112a),
- Freilegen der mobilen Struktur (112a) durch selektives Ätzen des Materials der zweiten isolierenden Schicht (120-124) hinsichtlich des Halbleitermaterials der zweiten Halbleiterschicht (112).

5. Verfahren nach einem der Ansprüche 1 bis 4, bei dem im Schritt b) wenigstens ein Motiv (M3) der Komponente (C) in der zweiten Halbleiterschicht (112) gebildet wird und mit dem Transistor verbunden wird, insbesondere mit dem Gate des Transistors.

6. Verfahren nach einem der Ansprüche 1 bis 5, bei dem im Schritt b) wenigstens ein Motiv (M3) der Komponente (C) in der zweiten Halbleiterschicht (112) gebildet wird und elektrisch mit dem Gate des Transistors durch eine elektrische Verbindung verbunden wird, die durch Ätzen in der zweiten Halbleiterschicht (112) im Verlauf des Schritts b) gebildet ist.

7. Verfahren nach einem der Ansprüche 1 bis 6, wobei der Transistor (T) ein Verstärkungstransistor ist, und/oder zu einer analogen Schaltung gehört, die mit wenigstens einer Verstärkerstufe versehen ist.

## Claims

1. A method for making a microelectronic device comprising, on a same substrate (100, 200), at least one electro-mechanical component (C) provided with a mobile structure of a monocrystalline semi-conductor material and means for actuating and/or detecting the mobile structure, and with at least one transistor (T),
the method comprising the following steps of:
a) providing a substrate provided with at least a first semi-conducting layer (100) including at least one region (104) in which a channel area of said transistor is provided,
- forming an insulating layer (106) onto the substrate (100), the insulating layer (106, 206) being placed on said first semi-conducting layer,
- making at least one first opening in said insulating layer (106) uncovering the first semi-conducting layer (100),
- removing an area of said insulating layer (106) to form a second opening in said insulating layer (106), said second opening uncovering said region (104) in which a channel area of said transistor is provided,
- forming a gate dielectric area (107) in said second opening,
- forming at least a semi-conducting sacrificial area (110) by epitaxy growth so as to form a monocrystalline semi-conductor material at the bottom of the first opening, and then,
- forming said second semi-conducting layer (112) by growth, so as to form a monocrystalline semi-conductor material on said semi-conducting sacrificial area (110) and a polycrystalline semi-conductor material area on said gate dielectric area,
b) etching the second semi-conducting layer (112, 212) so as to form at least one pattern (M1) of said mobile structure of said component in an area of monocrystalline semi-conductor material (112a, 212a) of the second semi-conducting layer, and at least one pattern (M'1) of gate of said transistor on a gate dielectric area located facing said given region,
c) removing said semi-conducting sacrificial area (110).

2. The method according to claim 1, wherein the material of the sacrificial area is selected so as to be able to be etched selectively towards the material of the first semi-conducting layer and the second semi-conducting layer.

3. The method according to claim 1 or 2, wherein:the material of the sacrificial area is SiₓGe₁₋ₓ.

4. The method according to one of claims 1 to 3, further comprising, after forming the semi-conducting sacrificial area (110), steps of:
- forming at least one second insulating layer (120-124), so as to cover the second semi-conducting layer (112) and surround the flanks of the mobile structure (112a),
- removing a given thickness of said second insulating layer (120-124) facing said structure (112a),
- releasing the mobile structure (112a) by etching selectively the second insulating layer (120-124) towards the semi-conductor material of the second semi-conducting layer (112).

5. The method according to one of claims 1 to 4, wherein, in step b), at least one pattern (M3) of said component (C) is formed in the second semi-conducting layer (112, 212) and connected to the transistor, in particular to the gate of said transistor.

6. The method according to one of claims 1 to 5, wherein, in step b), at least one pattern (M3) of said component (C) is formed in the second semi-conducting layer (112, 212) and electrically connected to the transistor gate by an electrical connection formed by etching in the second semi-conducting layer (112, 212) during step b).

7. The method according to one of claims 1 to 6, wherein the transistor (T) is an amplifying transistor and/or belongs to an analog circuit provided with at least one amplifying stage.
